# EUROPEAN PATENT SPECIFICATION

(11) **EP 0 450 840 B1**
(45) Date of publication and mention of the grant of the patent: **21.05.1997**
(21) Application number: 91302651.4
(22) Date of filing: 26.03.1991
(51) Int. Cl.: G03C 7/12, G02F 1/1335

(54) **Process for forming a colour filter**
Verfahren zur Herstellung eines Farbfilters
Procédé pour former un filtre de couleurs

(30) Priority: 02.04.1990 JP 87980/90
(43) Date of publication of application: 09.10.1991
(73) Proprietor: SEIKO EPSON CORPORATION, Shinjuku-ku Tokyo (JP)
(72) Inventor: Watanabe, Hiroshi, c/o SEIKO EPSON CORPORATION, Suwa-shi, Nagano-ken (JP); Aoki, Kazuo, c/o SEIKO EPSON CORPORATION, Suwa-shi, Nagano-ken (JP)
(74) Representative: Sturt, Clifford Mark

(56) References cited:
- EP-A- 0 079 111
- EP-A- 0 367 466
- PATENT ABSTRACTS OF JAPAN vol. 11, no. 178 (P-584)9 June 1987 & JP - A - 62 009 301.
- PATENT ABSTRACTS OF JAPAN vol. 12, no. 427 (P-784)11 November 1988 & JP - A - 63 159 808.
- PATENT ABSTRACTS OF JAPAN vol. 10, no. 247 (P-490)(2303) 26 August 1986 & JP - A - 61 077 014.

## Description

The present invention relates to a liquid crystal display colour filter and a process for forming a colour filter for a liquid crystal display.

Colour liquid crystal displays are known and used, for example, in display terminals of personal computers and the like. Liquid crystal displays can be classified largely into two types: the first is an active matrix type, employing an active element such as a thin film transistor (TFT), a diode and the like at every pixel and the second is a matrix type, utilising the steep threshold characteristic of the liquid crystal material.

In addition to the double layer super twisted nematic (STN) display and the film compensating STN display, which have been developed and are currently in service, it is expected that a simple matrix display using a ferro-dielectric liquid crystal material will be produced soon. However, in order to obtain a satisfactory picture quality, a substrate having a high degree of flatness is necessary to maintain a steep threshold characteristic uniform in the overall display area. Thus, a process for forming such a colour filter is indispensable for obtaining a colour display of the simple matrix type. Techniques for forming a colour filter, including printing processes, dyeing processes, electro-deposition processes and others have long been available. Further, a colour resist process, in which colour resist material, comprising pigment dispersed in a negative resist material, is formed into patterns according to a photo process, is on the way to being developed in recent years. This colour resist process is superior in positional precision and flatness as compared with the printing process, superior in heat resistance and light stability as compared with the dyeing process, and also superior in the degree of freedom as to pattern and in cost as compared with the electro-deposition process. Furthermore, problems regarding hue improvement, liquid stability and so forth have been solved recently, and thus the colour resist process has become a favoured technique.

However, a colour filter having a high degree of flatness and produced at a moderate cost cannot be obtained from the colour resist process by employing prior art colour filter forming techniques.

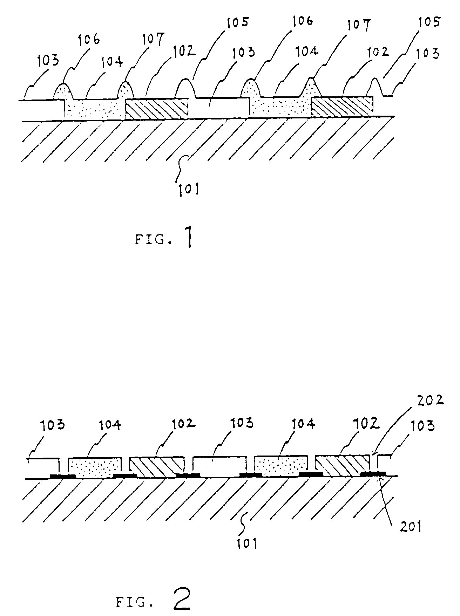

One such colour filter forming technique comprises a method for forming a shading area by superposing colour resists of a plurality of hues at each inter-pixel clearance of a partially produced display element. However, this method results in a substantial difference in level between a portion wherein the colour resists are superposed and a portion wherein they are not superposed, and hence a flat surface is not obtained at a cheap cost. A sectional view of a colour filter produced according to this forming technique is shown in Figure 1. As shown, first pixels 102 are initially provided on a transparent substrate 101, then second pixels 103 are formed with superposed portions 105. Further, third pixels 104 are then formed with superposed portions 106, 107 whereby the superposed portions project in a thickness almost the same as the thickness of the pixels. Thus, a flat surface is not obtained unless a thick surface film is formed on the colour filter and is ground flat, which leads to a high cost.

Another prior art colour filter forming technique comprises a method in which a black shading mask is formed at each inter-pixel clearance of a display element and a pixel of each hue is formed thereon. Projection of superposed portions, as shown in Figure 1, may be avoided by forming the black mask of a colour resist or the like as a thin shading layer 201, as shown in Figure 2. The shading layer 201 must be formed as a metal coating by vaporisation and patterned by a photo process. Thus, not only is the method expensive, it also results in a difference in level, due to clearances 202 between the pixels and the shading layer. Again, this can only be avoided by providing a flattened surface film on the colour filter, as in the case of superposing the colour resists.

Further prior art examples are found in the Patent Abstracts corresponding to JP-A-63-159808 and JP-A-62-009301.

It is an object of the present invention to provide an improved process for forming a liquid crystal display colour filter and an improved colour filter for a liquid crystal display.

According to the present invention, there is provided a process for forming a liquid crystal display colour filter as defined in claim 1.

The invention will now be described by way of example only, with reference to the accompanying drawings, in which:-
Figure 1 is a sectional view of a colour filter having superposed pixels of various hues formed according to a first known process;
Figure 2 is a sectional view of a colour filter having a thin metal black mask between pixels of different hues formed according to a second known process;
Figures 3(A), 3(B) and 3(C) are sectional views illustrating a process for forming a colour filter according to the present invention;
Figure 4 is a graph showing spectral transmission factors of pixels of a colour filter produced according to the present invention and filter elements employed during production;
Figures 5(A) and 5(B) are sectional views illustrating a further process for forming a colour filter according to the present invention; and
Figure 6 is a sectional view of a colour filter according to the present invention employed in a liquid crystal display.

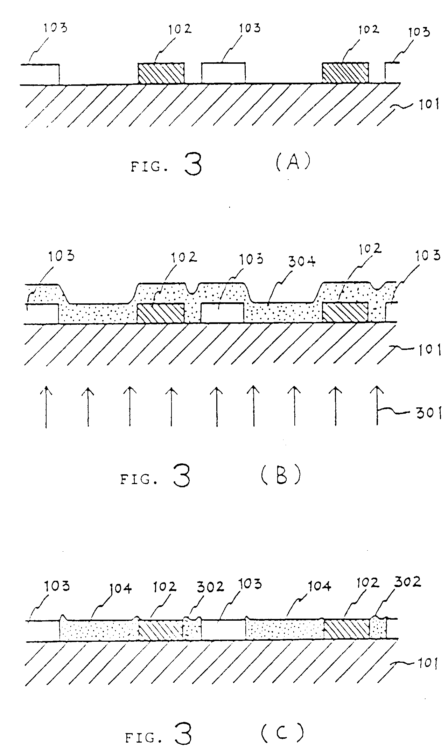

In a first step of a process according to the present invention for forming a colour filter with pixels of selected hues formed by means of colour resists, comprising pigments dispersed in a negative resist material, a transparent substrate 101 having pixels 102, 103 of two hues already formed thereon as shown in Figure 3 (A) is taken. Next, a film coating 304 of a colour resist of a further hue is formed over the whole surface of the transparent substrate 101 and the pixels 102, 103, and is exposed to UV light 301 through the substrate 101 as shown in Figure 3 (B). In this way, the clearances between the pixels 102, 103 are filled up with the colour resist of the further hue to provide further pixels 104 and clearance filling portions 302, and the remaining portions of the colour resist of the further hue may subsequently be removed, to provide a colour filter as shown in Figure 3 (C) having a high degree of flatness.

The degree of flatness is ensured by adjusting the exposure during the exposure step illustrated in Figure 3 (B) and thereby sensitising the film 104 to a desired thickness so as to unify the final thickness of the pixel 104 and the thicknesses of the already formed pixels 102, 103.

Furthermore, during the exposure step, a filter is provided between the exposure light source and the transparent substrate 101 for selectively cutting out light of a wavelength which would pass through the already formed pixels 102, 103. As a result, the colour resist coating film 304 is not sensitised through these pixels during the exposure by the light 301 in the step shown in Figure 3 (B). This prevents a residual layer of the colour resist coating film from being formed on the pixels 102, 103.

### EXAMPLE 1

In the present examples, colour resist material manufactured by Fuji Hunt Electronics Technology Co. Ltd. under the trade name COLOR MOSAIC was used, being designated CBV for blue, CRY for red and CGY for green. The negative resist material included in this colour resist material is a photo-sensitive acrylic resin and is thus susceptible to oxygen in the air, and therefore it is preferable to have an oxygen cutoff film (also manufactured by Fuji Hunt Electronics Technology Co. Ltd., under the trade name CP) coated thereon before exposure to improve sensitivity. In this case, the colour resists CBV, CRY and CGY each have a high sensitivity at 10 to 30 mj/cm². An extra high voltage mercury arc lamp was used for the exposure light source. Further, a soda glass was used for the transparent substrate 101.

In this first example, colour filter pixels 102 and 103 of red and green were formed in stripes on the aforementioned transparent glass substrate 101, by means of exposure from its front side, and then a blue colour resist coating film 304 was formed thereafter and exposed from behind.

More especially, a CRY film was coated on the transparent glass substrate 101 by means of a spin coater, and was then pre-heated at 70°C for two minutes, irradiated by UV rays from the extra high voltage mercury arc lamp at 10 mj to 30 mj through a photo-mask, and developed by means of an alkaline developer (manufactured by Fuji Hunt Electronics Technology Co. Ltd. under the trade name CD) and dried and burned to form the pixels 102. After this, the pixels 103 were formed from a CGY film beside the CRY pixels 102 and 10 to 30 µm apart therefrom through a similar process. In this connection, the CRY pixels 102 may be formed either before or after the CGY pixels 103 as desired. Next, a CBV film 304 was coated on the transparent glass substrate 101 and pre-baked before exposure through the substrate 101.

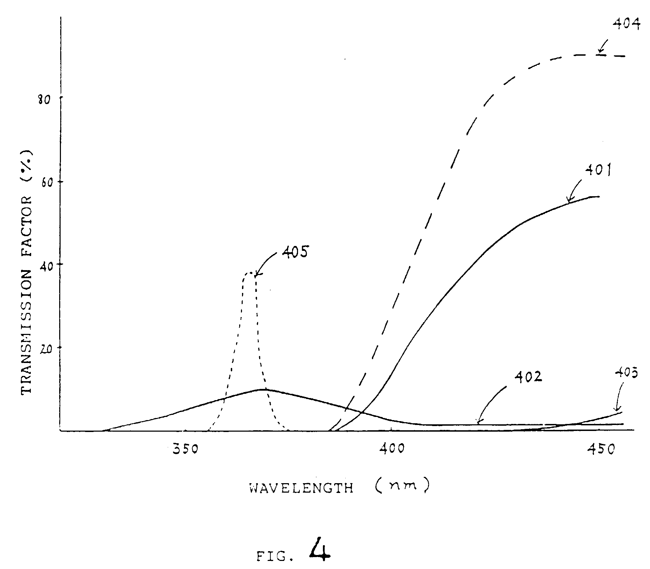

Now, transmission factors for CRY, CGY and CBV film for shorter wavelengths are shown in Figure 4. The reference numeral 401 denotes a spectral transmission factoroorf the CBV film, the reference numeral 402 denotes that of the CRY film, and the reference numeral 403 denotes that of the CGY film. The CRY film has a photo-sensitive band in the range 330 to 415 nm, the CGY film has a photo-sensitive band in the range 330 to 405 nm, and the CBV film has a photo-sensitive band in the range 350 to 420 nm. Therefore, if the CBV film 304 is exposed from behind the transparent substrate 101 on which the CRY and CGY pixels 102, 103 are formed, light of the wave length 365 nm from the ultra high voltage mercury arc lamp will pass through the CRY pixels 102. For this reason, a UV filter having a spectral transmission factor indicated by the reference numeral 404 is provided mid-way between the light source and the glass substrate 101 thereby selectively cutting out the light passing through the CRY pixels 102 for the most part.

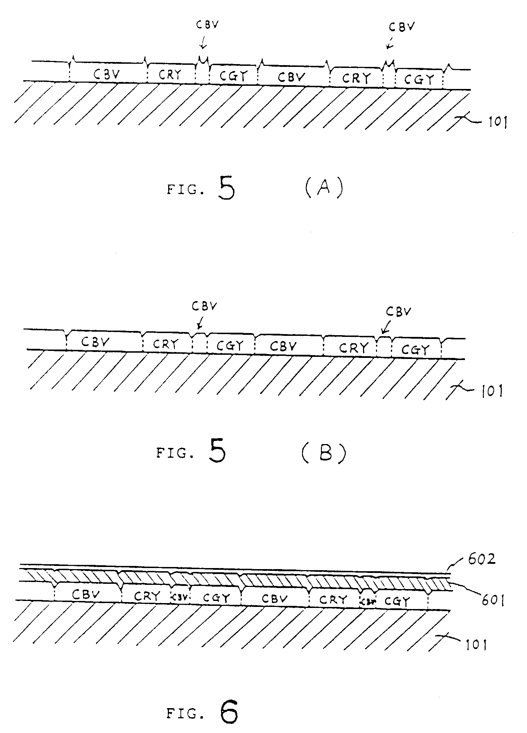

Using the filter, therefore, the substrate 101 having the CBV film 304 coated thereon was exposed from behind through a photo-mask covering the whole area of the substrate, and developed and burned, thereby obtaining a flat colour filter as shown in Figure 5 (A).

One set of samples having the oxygen cutoff film CP coated on the CBV film 304 was exposed further to light from behind the transparent substrate 101 at 20 to 100 mj/cm², and another set of samples without a CP coating was exposed at 150 to 300 mj/cm², for obtaining a desired surface state free from residual CBV film on the CRY and CGY pixels. It was found that a flat surface free from projections as shown in Figure 5 (B) was obtained by exposing the samples without the CP coating on the CBV film at 150 to 200 mj/cm² and those with the CP coating thereon at 20 to 30 mj/cm².

### EXAMPLE 2

In a second example, blue and green colour filter pixels 102, 103 were first formed in stripes on the transparent glass substrate 102 mentioned above by exposure to light from the front, and finally a red colour resist coating film 304 was formed and exposed from behind.

The CGY and CBV pixels 102, 103 were formed as in the case of Example 1 and the CRY film 304 was coated thereon. Then, after pre-baking, an interference filter having the spectral transmission factor indicated by the reference numeral 405 in Figure 4 was interposed between the light source and the glass substrate 101 for exposing the CRY film 304. One set of samples with a CP coating on the CRY film was exposed from behind at 15 to 100 mj/cm², and another set without a CP coating thereon was exposed at 120 to 300 mj/cm². A colour filter 3 from a residual CRY layer on the CGY and CBV pixels and having a high degree of flatness was obtained as shown in Figure 5 (A) and 5 (B).

A liquid crystal display may be produced using the colour filter of the present invention by further forming a flattened film 601 as shown in Figure 6 from a polyimide resin, an acrylic resin, an epoxy resin or an urethane resin on the pixels, and then forming a transparent conductive ITO film 602 on the film 601, through sputtering techniques, to form an electrode substrate for a double layer STN display. A uniform display having a high shading efficiency and with a contrast ratio of 1:20 or more may thus be provided.

## Claims

1. A process for forming a liquid crystal display colour filter, comprising:
forming a layer comprising separate colour filter elements (102) of a first hue on a transparent substrate (101) from colour resist material having pigment dispersed in a negative resist material;
coating said transparent substrate with a film (304) and thereby filling the clearances between the filter elements (102);
exposing said film to light through said transparent substrate;
characterised:
by flattening the surface of the colour filter in the exposing step by adjusting the exposure to sensitise the coating film to a desired thickness,
by positioning filtering means between the transparent substrate and the source of exposing light, said filtering means being arranged to selectively exclude light of a wavelength which would pass through said colour filter elements (102,103); and
in that the film (304) is of a colour resist material of a second hue and thus further colour filter pixels (104) are provided by the colour resist material of the second hue filling the clearances.

2. A process according to claim 1 comprising forming colour filter elements (103) of a third hue on the transparent substrate (101) from colour resist material having pigment dispersed in a negative resist material prior to coating the transparent substrate with the film (304).

3. A process according to claim 2 wherein clearance filling portions (302) between the colour filter elements of the first and the third hue are also provided by the colour resist material of the second hue.

4. A process according to any preceding claim, wherein the second hue is red or blue.

5. A process as claimed in any preceding claim, wherein the hues are selected from the three primary colours of red, green and blue.

## Patentansprüche

1. Verfahren zur Herstellung eines Flüssigkristallanzeige-Farbfilters, umfassend:
das Ausbilden einer Schicht, umfassend separate Farbfilterelemente (102) eines ersten Farbtons auf einem transparenten Substrat (101), aus einem Farbresistmaterial mit einem in einem Negativ-Resistmaterial verteilten Pigment;
das Beschichten des transparenten Substrats mit einem Film (304) und dadurch das Auffüllen der Zwischenräume zwischen den Filterelementen (102),
das Belichten des Films mit Licht durch das transparente Substrat hindurch,
gekennzeichnet durch:
das Ebenmachen der Oberfläche des Farbfilters in dem Belichtungsschritt durch Einstellen der Belichtung zum Sensibilisieren des Beschichtungsfilms auf eine gewünschte Dicke,
das Positionieren von Filtermitteln zwischen dem transparenten Substrat und der Quelle des Belichtungslichts, wobei die Filtermittel zum wahlweisen Ausschließen von Licht einer Wellenlänge eingerichtet sind, welches durch die Farbfilterelemente (102, 103) hindurchgehen würde, und dadurch,
daß der Film (304) aus einem Farbresistmaterial eines zweiten Farbtons besteht und somit weitere Farbfilterpixel (104) durch das Farbresistmaterial mit dem zweiten Farbton, welches die Zwischenräume auffüllt, vorgesehen sind.

2. Verfahren nach Anspruch 1, umfassend das Ausbilden von Farbfilterelementen (103) eines dritten Farbtons auf dem transparenten Substrat (101) aus einem Farbresistmaterial mit einem in einem Negativ-Resistmaterial verteilten Pigment vor dem Beschichten des transparenten Substrats mit dem Film (304).

3. Verfahren nach Anspruch 2, worin Zwischenraum füllende Abschnitte (302) zwischen den Farbfilterelementen mit dem ersten und dem dritten Farbton ferner durch das Farbresistmaterial mit dem zweiten Farbton vorgesehen sind.

4. Verfahren nach einem der vorhergehenden Ansprüche, worin der zweite Farbton rot oder blau ist.

5. Verfahren nach einem der vorhergehenden Ansprüche, worin die Farbtöne aus den drei Primärfarben rot, grün und blau ausgewählt werden.

## Revendications

1. Procédé pour former un filtre couleur d'écran à cristaux liquides, comprenant les opérations suivantes :
former une couche comportant des éléments de filtre couleur (102) distincts d'une première nuance sur un substrat transparent (101) en une matière de protection contre la couleur comprenant un pigment dispersé dans une matière de protection négative ;
enduire ledit substrat transparent d'un film (304) en comblant ainsi les écarts entre les éléments de filtre (102) ;
exposer ledit film à la lumière à travers ledit substrat transparent ;
caractérisé :
par l'aplanissement de la surface du filtre couleur au cours de l'étape d'exposition en ajustant l'exposition pour sensibiliser le film de revêtement à une épaisseur souhaitée,
par le positionnement des moyens de filtrage entre le substrat transparent et la source de lumière d'exposition, lesdits moyens de filtrage étant agencés pour exclure sélectivement une lumière d'une certaine longueur d'onde qui traverserait lesdits éléments de filtre couleur (102, 103) ; et
en ce que le film (304) est en une matière de protection contre la couleur d'une seconde teinte, et donc que d'autres pixels de filtre couleur (104) sont formés par la matière de protection contre la couleur de la seconde teinte qui remplit les écarts entre les éléments de filtre.

2. Procédé selon la revendication 1, comprenant la formation d'éléments de filtre couleur (103) d'une troisième teinte sur le substrat transparent (101) en une matière de protection contre la couleur comprenant un pigment dispersé dans une matière de protection négative avant de recouvrir le substrat transparent par le film (304).

3. Procédé selon la revendication 2, dans lequel les parties de remplissage des écarts (302) entre les éléments de filtre couleur de la première et de la troisième teintes sont aussi formées par la matière de protection contre la couleur de la seconde teinte.

4. Procédé selon l'une quelconque des revendications précédentes, dans lequel la seconde teinte est rouge ou bleue.

5. Procédé selon l'une quelconque des revendications précédentes, dans lequel les teintes sont choisies parmi les trois couleurs primaires : rouge, vert et bleu.
